# EUROPEAN PATENT APPLICATION

(11) **EP 3 255 683 A1**
(43) Date of publication of application: **13.12.2017**
(21) Application number: 16746664.8
(22) Date of filing: 03.02.2016
(51) Int. Cl.: H01L 33/14, H01L 33/32

(54) **LIGHT-EMITTING ELEMENT AND PRODUCTION METHOD FOR LIGHT-EMITTING ELEMENT**

(30) Priority: 06.02.2015 JP 2015021875
(71) Applicant: STANLEY ELECTRIC CO., LTD., Tokyo 153-8636 (JP)
(72) Inventor: OBATA, Toshiyuki, Shunan-shi Yamaguchi 745-8648 (JP)
(74) Representative: Carstens, Dirk Wilhelm
(86) International application number: PCT/JP2016/053257
(87) International publication number: WO 2016/125833

(57) **Abstract**

A light-emitting element that can improve external quantum efficiency by controlling a dopant concentration in the vicinity of an interface between a light-emitting layer region and a carrier blocking layer and thus can improve light output, and a method for producing such a light-emitting element are provided.

A nitride-based semiconductor light-emitting element 1 includes: a first semiconductor layer 20 of a first conductivity type; a second semiconductor layer 50 of a second conductivity type different from the first conductivity type; a carrier blocking layer 40 of the second conductivity type, provided on a surface of the second semiconductor layer 50 closer to the first semiconductor layer 20; and a light-emitting layer region 30 including a light-emitting layer, provided between the first semiconductor layer 20 and the carrier blocking layer 40. The maximum value of the concentration of an impurity of the second conductivity type in a predetermined region from an interface with the light-emitting layer region 30 in the carrier blocking layer 40 is higher than 5 × 10¹⁹ cm⁻³.

## Description

### TECHNICAL FIELD

The present invention relates to a light-emitting element and a method for producing such a light-emitting element. In particular, the present invention relates to a nitride-based compound semiconductor light-emitting element and a method for producing the light-emitting element.

### BACKGROUND ART

At present, gas light sources such as deuterium and mercury are used as deep ultraviolet light sources with an emission wavelength of 350 nm or less. Such gas light sources have disadvantages such as their short lifetimes and large sizes. Moreover, mercury is a substance becoming subject to regulation by the treaty. Thus, the realization of a deep ultraviolet light-emitting element using a semiconductor, capable of solving these disadvantages and being handled easily, has been expected.

Such a light-emitting element using a semiconductor, however, has problems of low light output and low light-emitting efficiency as compared to a gas light source such as a deuterium gas lamp or a mercury gas lamp. In a nitride semiconductor light-emitting element, since the effective mass of an electron is smaller than that of a hole and the carrier concentration is high, the electrons pass through an active layer (region) and overflow into a p-type layer, resulting in reduced light-emitting efficiency. This is one cause for the insufficient light output in the semiconductor light-emitting element.

The problem of the overflow of the electrons into the p-type layer in the nitride semiconductor light-emitting element is not a problem occurring only in the deep ultraviolet light-emitting elements with an emission wavelength of 350 nm or less. For example, Patent Literature 1 describes a technique to prevent the outflow of electrons from an active layer region into a p-type layer and thus enhance light-emitting efficiency by forming a carrier blocking layer having a bandgap larger than that of the active layer between the active layer and the p-type layer in a semiconductor light-emitting element with an emission wavelength greater than 350 nm. Moreover, Non-Patent Literature 1 describes an attempt for the application of the carrier blocking layer as described above also in a deep ultraviolet light-emitting element. Non-Patent Literature 1 shows that interposing an undoped thin AlN layer between an active layer and a p-type layer improves light-emitting efficiency.

Moreover, the characteristics of a light-emitting diode in which barrier layers of an InGaN/GaN multiple quantum well are doped with Mg have been reported (see Non-Patent Literature 2, for example). According to the technique described in Non-Patent Literature 2, a light-emitting diode with a barrier layer doped with Mg can improve light output more than a light-emitting diode with a barrier layer undoped with Mg.

### CITATION LIST

### PATENT LITERATURE

Patent Literature 1: Japanese Patent Application Laid-Open No. 2007-88269
Non-Patent Literature 1: Y.H. Zhu, S. Sumiya, J.C. Zhang, M. Miyoshi, T. Shibata, K. Kosaka, M. Tanaka and T. Egawa, "Improved performance of 264 nm emission AlGaN-based deep ultraviolet light-emitting diodes", ELECTRON ICS LETTERS 44, 493 (2008)
Non-Patent Literature 2: Sang-Heon Han, Chu-Young Cho, Sang-Jun Lee, Tae-Young Park, Tae-Hun Kim, Seung Hyun Park, Sang Won Kang, Je Won Kim, Yong Chun Kim, and Seong-Ju Park, "Effect of Mg doping in the barrier or InGaN/GaN multiple quantum well on optical power of light-emitting diodes", APPLIED PHYSICS LETTERS 96, 051113 (2010).

### SUMMARY OF INVENTION

### TECHNICAL PROBLEM

However, the light-emitting efficiency is still insufficient, and further improvement in light-emitting efficiency has been desired. While the techniques described in Patent Literature 1 and Non-Patent Literature 1 describe that the introduction of the carrier blocking layer can improve light-emitting efficiency, no attention is paid to a doping concentration in the carrier blocking layer itself or at an interface between the carrier blocking layer and another semiconductor layer. Moreover, while the technique described in Non-Patent Literature 2 focuses on doping the barrier layer with Mg, this technique also pays no attention to a doping concentration at an interface between a light-emitting layer region and another semiconductor layer.

Thus, it is an object of the present invention to provide a light-emitting element that can improve light-emitting efficiency by controlling a dopant concentration in the vicinity of an interface between a light-emitting layer region and a carrier blocking layer and a method for producing such a light-emitting element.

### SOLUTION TO PROBLEM

In order to achieve the aforementioned object, the present invention provides a nitride-based semiconductor light-emitting element including: a first semiconductor layer of a first conductivity type; a second semiconductor layer of a second conductivity type different from the first conductivity type; a carrier blocking layer of the second conductivity type, provided on a surface of the second semiconductor layer closer to the first semiconductor layer; and a light-emitting layer region having a light-emitting layer, provided between the first semiconductor layer and the carrier blocking layer. A maximum value of a concentration of an impurity of the second conductivity type in a predetermined region from an interface with the light-emitting layer region in the carrier blocking layer is higher than 5 × 10¹⁹ cm⁻³.

In the above-described nitride-based semiconductor light-emitting element, the predetermined region is preferably a region of 10 nm from the interface toward the second semiconductor layer.

In the above-described nitride-based semiconductor light-emitting element, the first semiconductor layer may be provided on a semiconductor substrate, and the first semiconductor layer, the second semiconductor layer, the light-emitting layer region, and the carrier blocking layer may be configured to include an AlGaN-based semiconductor.

In the above-described nitride-based semiconductor light-emitting element, the semiconductor substrate may be an AlN substrate, and the first semiconductor layer may be provided on a C-plane of the AlN substrate.

In the above-described nitride-based semiconductor light-emitting element, the impurity of the second conductivity type may be Mg, Zn, Ca, C, or Be.

In order to achieve the aforementioned object, the present invention provides a method for producing a nitride-based semiconductor light-emitting element, including: a first semiconductor layer forming step of forming a first semiconductor layer of a first conductivity type on a semiconductor substrate; a light-emitting layer region forming step of forming a light-emitting layer region including a light-emitting layer on the first semiconductor layer; a carrier blocking layer forming step of forming a carrier blocking layer on the light-emitting layer region; and a second semiconductor layer forming step of forming a second semiconductor layer of a second conductivity type different from the first conductivity type on the carrier blocking layer. The carrier blocking layer forming step includes an impurity introducing step of making a maximum value of a concentration of an impurity of the second conductivity type in a predetermined region from an interface with the light-emitting layer region in the carrier blocking layer higher than a predetermined concentration (5 × 10¹⁹ cm⁻³)_{.}

### ADVANTAGEOUS EFFECTS OF THE INVENTION

According to the light-emitting element and the method for producing a light-emitting element of the present invention, a light-emitting element that can improve light-emitting efficiency by controlling a dopant concentration in the vicinity of the interface between the light-emitting layer region and the carrier blocking layer and a method for producing such a light-emitting element can be provided.

### BRIEF DESCRIPTION OF DRAWINGS

FIG. 1 is a schematic view illustrating a cross section of a light-emitting element according to an embodiment.
FIG. 2 is a cross-sectional view in the vicinity of a light-emitting layer region according to the embodiment.
FIG. 3 is a schematic view illustrating part of an energy band diagram of semiconductor layers that constitute the light-emitting element according to the embodiment.

### DESCRIPTION OF EMBODIMENTS

### [Embodiment]

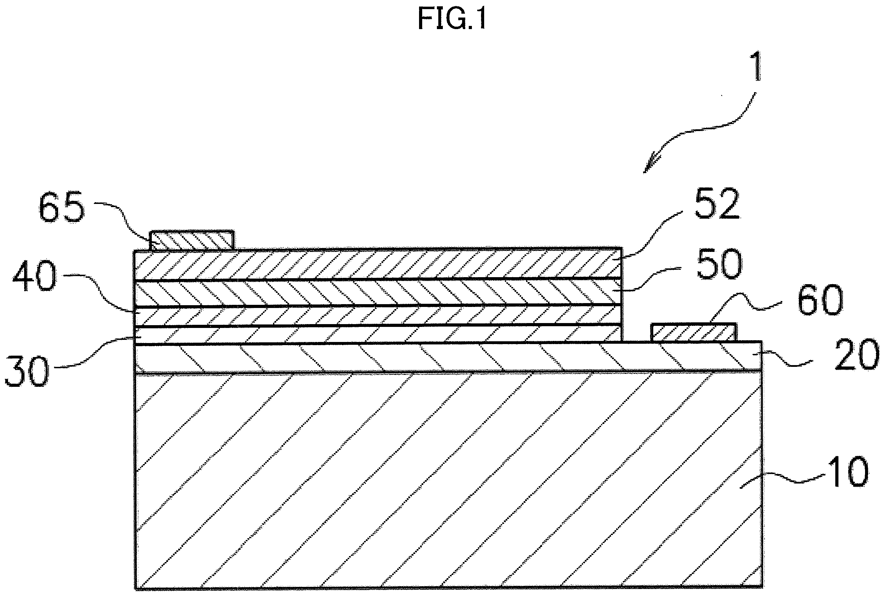

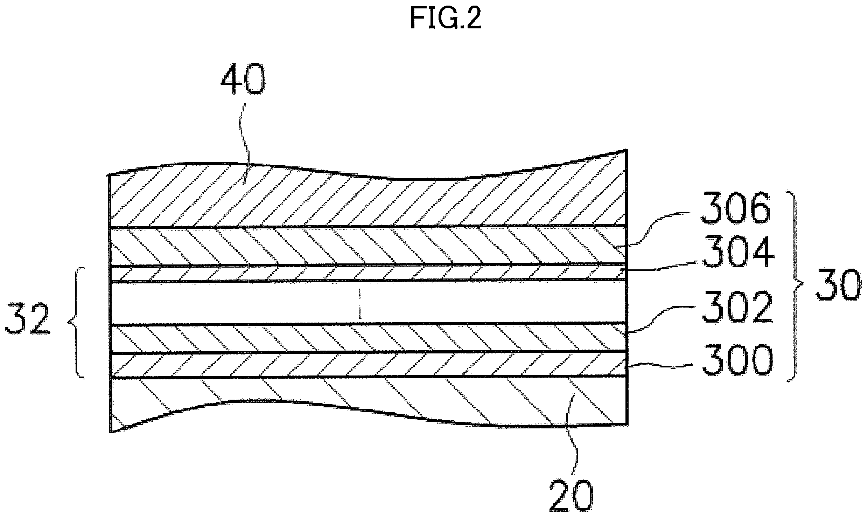

FIG. 1 shows an example of a schematic cross section of a light-emitting element according to an embodiment of the present invention. FIG. 2 shows an example of a schematic cross section in the vicinity of a light-emitting layer region according to the embodiment of the present invention. Note that the drawings described in the present embodiment are merely schematic views, and thicknesses, sizes, and the like of respective semiconductor layers shown in the respective drawings do not necessarily reflect their actual thicknesses, sizes, and the like.

### (Schematic structure of light-emitting element 1)

The light-emitting element 1 according to the present embodiment mainly is formed from a GaN-based or AlGaN-based group III-V compound semiconductor, for example. The light-emitting element 1 is a light-emitting diode (LED), a laser diode, or the like, serving as a light-emitting element for emitting light in the deep ultraviolet region. The light-emitting element 1 has a rectangular shape in a planar view by way of example. The light-emitting element 1 includes: a substrate 10; a first semiconductor layer 20 of a first conductivity type, which is provided on the substrate 10; a light-emitting layer region 30 provided on the first semiconductor layer 20; a carrier blocking layer 40 provided on the light-emitting layer region 30; a second semiconductor layer 50 of a second conductivity type different from the first conductivity type, which is provided on the carrier blocking layer 40; and a third semiconductor layer 52 provided on the second semiconductor layer 50.

In the present embodiment, the description that "another semiconductor layer is provided on one semiconductor layer" includes a configuration in which the another semiconductor layer is provided immediately above the one semiconductor layer and a configuration in which still another semiconductor layer is provided between the one semiconductor layer and the another semiconductor layer (i.e., a configuration in which the another semiconductor layer is provided above the one semiconductor layer).

The light-emitting element 1 further includes: a first electrode 60 provided on part of a region of the first semiconductor layer 20 opposite to the substrate 10; and a second electrode 65 provided on a region of a surface of the third semiconductor layer 52 opposite to the second semiconductor layer 50.

Here, the first semiconductor layer 20 includes a dopant as an impurity of the first conductivity type, and the second semiconductor layer 50 and the third semiconductor layer 52 are each configured to include a dopant of the second conductivity type different from the first conductivity type. In the present embodiment, the carrier blocking layer 40 is configured to include a dopant of the second conductivity type. The light-emitting layer region 30 is configured to include a quantum well layer 32 including well layers and barrier layers that are alternately layered.

The light-emitting layer region 30 further includes a spacer layer 306 provided between the carrier blocking layer 40 and the quantum well layer 32. The spacer layer 306 regulates the concentration of an impurity of the second conductivity type in the vicinity of an interface between the quantum well layer 32 and the spacer layer 306 to be smaller than or equal to a predetermined concentration. For example, the spacer layer 306 is provided to be in contact with the well layer or the barrier layer closer to the carrier blocking layer 40 in the quantum well layer 32. The spacer layer 306 has a function and a configuration to prevent the impurity from the carrier blocking layer 40 from substantially reaching the vicinity of the interface or the interface between the well layer or the barrier layer closest to the carrier blocking layer 40 and the spacer layer 306.

The spacer layer 306 and the carrier blocking layer 40 are further configured so that the maximum value of the concentration of the impurity of the second conductivity type in a range of a predetermined distance (hereinafter, referred to also as a "predetermined region") along a thickness direction of the carrier blocking layer 40 from the interface with the light-emitting layer region (i.e., the interface between the spacer layer 306 and the carrier blocking layer 40) in the carrier blocking layer 40 is higher than 5 × 10¹⁹ cm⁻³. The maximum value of the concentration of the impurity of the second conductivity type in the predetermined region being higher than 5 × 10¹⁹ cm⁻³ means that at least one place in the predetermined region needs to have a concentration of the impurity of the second conductivity type higher than 5 × 10¹⁹ cm⁻³. There is no need for the concentration profile of the impurity of the second conductivity type in the predetermined region to be constant.

The present inventor has found out that the light-emitting efficiency (i.e., external quantum efficiency) of the light-emitting element is improved by setting the impurity concentration in the predetermined region in the carrier blocking layer 40 to be greater than or equal to a predetermined concentration in the course of studying the behaviors of the dopants in the respective semiconductor layers that constitute the light-emitting element, the effects of the dopants on the respective semiconductor layers, the effects of dopant concentrations on the external quantum efficiency, and the like as well as methods for producing the semiconductor layers, and the like.

### (Details of structure of light-emitting element 1)

A case where the first conductivity type is n-type and the second conductivity type is p-type will be described by way of example.

### (Substrate 10)

The substrate 10 is a semiconductor substrate having a predetermined thickness and plane orientation or a monocrystalline substrate such as sapphire. For example, a silicon carbide (SiC) substrate, a gallium nitride (GaN) substrate, an aluminum nitride (AlN) substrate having high thermal conductivity, or the like may be used when a semiconductor substrate is employed as the substrate 10. In the present embodiment, a C-plane A1N substrate is employed as the substrate 10 by way of example in order to prevent the occurrence of crystal defects such as dislocation through the use of a lattice-matched substrate and thus deposit high-quality semiconductor layers. When a material, such as sapphire, having a lattice constant largely different from that of the first semiconductor layer 20 is used in the substrate 10, a buffer layer may be provided between the substrate 10 and the first semiconductor layer 20.

### (Respective semiconductor layers)

The first semiconductor layer 20, the light-emitting layer region 30 including the spacer layer 306, the carrier blocking layer 40, the second semiconductor layer 50, and the third semiconductor layer 52 are each formed mainly from a nitride-based compound semiconductor. These semiconductor layers are each formed from a compound semiconductor represented by AlₓGa₁₋ₓN (wherein 0 ≤ x ≤ 1), for example. Here, the carrier blocking layer 40 is a semiconductor layer to reduce the migration of carriers (for example, electrons) migrating from the first semiconductor layer 20 side into the second semiconductor layer 50 side.

Specifically, the first semiconductor layer 20 is formed from an AlGaN-based compound semiconductor including an n-type dopant. The carrier blocking layer 40, the second semiconductor layer 50, and the third semiconductor layer 52 are each formed from an AlGaN-based compound semiconductor including a p-type dopant.

More specifically, the first semiconductor layer 20 is formed from AlₓGa₁₋ₓN (wherein 0 ≤ x ≤ 1) including a predetermined concentration of an n-type dopant such as Si or Se. The first semiconductor layer 20 is formed from an Al_{0.75}Ga_{0.25}N layer including an n-type dopant by way of example. The concentration of the n-type dopant included in the first semiconductor layer 20 is greater than or equal to 1 × 10¹⁷ cm⁻³ and smaller than or equal to 5 × 10²⁰ cm⁻³.

The carrier blocking layer 40 is formed from AlₓGa₁₋ₓN (wherein 0 ≤ x ≤ 1) including a predetermined concentration of a p-type dopant such as Mg, Zn, Ca, C, or Be. The carrier blocking layer 40, however, may alternatively be an undoped layer. In the present embodiment, the carrier blocking layer 40 has a function to reduce the propagation of carriers propagating from the first semiconductor layer 20 side into the second semiconductor layer 50 side. Thus, the carrier blocking layer 40 is preferably made of a material having a larger bandgap than the other semiconductor layers. By way of example, the carrier blocking layer 40 is formed from AlN including a p-type dopant. The concentration of the p-type dopant included in the carrier blocking layer 40 is greater than or equal to 1 × 10¹⁷ cm⁻³ and smaller than or equal to 5 × 10²⁰ cm⁻³. Here, the dopant concentration may be nonuniform, or there may be partially an undoped region.

The second semiconductor layer 50 and the third semiconductor layer 52 are each formed from AlₓGa₁₋ₓN (wherein 0 ≤ x ≤ 1) including a predetermined concentration of a p-type dopant. Here, the second semiconductor layer 50 has a function as a cladding layer, and the third semiconductor layer 52 has a function as a contact layer. By way of example, the second semiconductor layer 50 is formed from Al_{0.8}Ga_{0.2}N including a p-type dopant, and the third semiconductor layer 52 is formed from GaN including a p-type dopant. The concentration of the p-type dopant included in the second semiconductor layer 50 is greater than or equal to 1 × 10¹⁷ cm⁻³ and smaller than or equal to 5 × 10²⁰ cm⁻³. The concentration of the p-type dopant included in the third semiconductor layer 52 is greater than or equal to 1 × 10¹⁷ cm⁻³ and smaller than or equal to 5 × 10²⁰ cm⁻³.

The light-emitting layer region 30 emits light of a wavelength in a predetermined range upon the external supply of current. Specifically, the light-emitting layer region 30 has a configuration to emit light of a wavelength including the deep ultraviolet region (for example, light with a peak emission wavelength of 200 nm or more and 350 nm or less). Here, the light-emitting layer region 30 is formed to include the quantum well layer 32, as a light-emitting layer, in which the barrier layers (for example, the barrier layer 300) and the well layers (for example, the well layers 302 and 304) are alternately layered between the first semiconductor layer 20 and the carrier blocking layer 40, more specifically, between the first semiconductor layer 20 and the spacer layer 306. By way of example, the quantum well layer 32 includes a pair of an Al_{0.65}Ga_{0.35}N layer including an n-type dopant, which serves as a barrier layer, and an Al_{0.50}Ga_{0.50}N layer, which serves as an undoped well layer. By way of example, the spacer layer 306 including undoped Al_{0.65}Ga_{0.35}N (or an undoped barrier layer) is formed between the carrier blocking layer 40 and the quantum well layer 32.

Note that the light-emitting layer region 30 may have a multiple quantum well structure including pairs of a barrier layer and a well layer (i.e., a structure in which barrier layers and well layers are alternately layered). The concentration of the n-type dopant included in the barrier layer is greater than or equal to 1 × 10¹⁷ cm⁻³ and smaller than or equal to 5 × 10²⁰ cm⁻³. Here, the barrier layer may or may not include the n-type dopant. The "undoped" semiconductor layer in the present embodiment refers to a semiconductor layer formed without positive addition of a dopant during the production process thereof and does not preclude the inclusion of an unavoidable impurity.

The spacer layer 306 has a function to confine large part of the dopant diffused from the carrier blocking layer 40 toward the well layer 304 within the spacer layer 306.

No impurity is introduced into the spacer layer 306 while the spacer layer 306 is being formed after the formation of the quantum well layer 32. Immediately after the formation of the spacer layer 306, i.e., from the start of the formation of the carrier blocking layer 40 (in other words, from the interface between the spacer layer 306 and the carrier blocking layer 40), the impurity is introduced. Furthermore, the impurity is introduced so that the maximum value of the concentration of the impurity of the second conductivity type in the predetermined region from the interface with the light-emitting layer region 30 in the carrier blocking layer 40 becomes higher than the impurity concentration in the light-emitting layer region 30 and becomes greater than or equal to the predetermined concentration (exceeding 5 × 10¹⁹ cm⁻³).

Consequently, the maximum value of the concentration of the impurity of the second conductivity type in the predetermined region from the interface with the light-emitting layer region 30 in the carrier blocking layer 40 becomes higher than the concentration of the impurity of the second conductivity type in the light-emitting layer region 30. While the spacer layer 306 is preferably formed to have a thickness nearly equal to, or larger than, that of the carrier blocking layer 40 and formed to be thicker than the well layer and the barrier layer included in the light-emitting layer region 30, the spacer layer 306 may be thinner than the carrier blocking layer.

### (First electrode 60 and second electrode 65)

The first electrode 60 is formed from a material that forms an ohmic junction with the first semiconductor layer 20. Similarly, the second electrode 65 is formed from a material that forms an ohmic junction with the third semiconductor layer 52. The first electrode 60 and the second electrode 65 are each configured to include an electrode layer formed from a single material or a combination of a plurality of electrode layers partially formed from different materials.

For example, when the first semiconductor layer 20 is an n-type semiconductor, the first electrode 60 is made by forming a Ti layer, an Al layer, and an Au layer, each having a predetermined thickness, in this order from the first semiconductor layer 20 side. When the third semiconductor layer 52 is a p-type semiconductor, the second electrode 65 is made by forming an Ni layer and an Au layer, each having a predetermined thickness, in this order from the third semiconductor layer 52 side. Note that materials to constitute the first electrode 60 and the second electrode 65 are not limited thereto. Other metallic materials, electrically-conductive oxide materials, and/or electrically-conductive polymer materials, for example, may be employed as long as the materials can form an ohmic junction with the first semiconductor layer 20 and the third semiconductor layer 52.

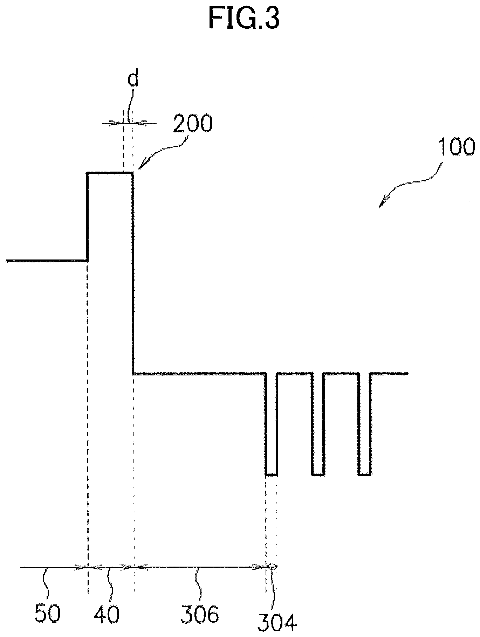

FIG. 3 shows part of a schematic energy band diagram of the semiconductor layers that constitute the light-emitting element according to the present embodiment.

FIG. 3 shows a schematic conceptual band diagram 100 for part of the semiconductor layers that form the light-emitting element 1. FIG. 3 shows that the semiconductor layers are provided in the order of part of the second semiconductor layer 50, the carrier blocking layer 40, the spacer layer 306, and the well layer 304 from the left side. In the present embodiment, the maximum value of the concentration of the p-type dopant in the predetermined region in the carrier blocking layer 40 is controlled to be higher than 5 × 10¹⁹ cm⁻³.

The predetermined region in the present embodiment is preferably a region of 10 nm along the thickness direction of the carrier blocking layer 40 from the carrier blocking layer 40 toward the second semiconductor layer 50. In other words, the predetermined region is a region with a thickness of 10 nm (thickness represented by d in FIG. 3) from the interface between the spacer layer 306 and the carrier blocking layer 40 toward the carrier blocking layer 40. The maximum value of the impurity concentration of the p-type dopant in the predetermined region in the carrier blocking layer 40 is higher than 5 × 10¹⁹ cm⁻³. Note that the impurity concentration gradually decreases along the thickness direction of the spacer layer 306 from the carrier blocking layer 40 side toward the well layer 304 positioned closest to the carrier blocking layer 40.

Such a concentration profile can be achieved by growing semiconductor layers with predetermined thicknesses while doping each of the semiconductor layers with a predetermined dopant at a predetermined doping rate from the start of the formation of the carrier blocking layer 40 under a predetermined growth temperature reached according to a predetermined up-and-down profile of growth temperature in the course of forming each of the semiconductor layers.

### (Method for producing light-emitting element 1)

An example of a method for producing the light-emitting element 1 according to the present embodiment will be described below.

First, an AlGaN-based semiconductor layered structure including a plurality of compound semiconductor layers is formed on the substrate 10 by a metal organic chemical vapor deposition method (MOCVD method), for example, at predetermined growth temperatures with predetermined amounts of growth time. Specifically, the first semiconductor layer 20 including AlₓGa₁₋ₓN (wherein 0 ≤ x ≤ 1, the same applies hereinafter) doped with an n-type dopant is first formed on the substrate 10 (a first semiconductor layer forming step). Next, the light-emitting layer region 30 is formed on the first semiconductor layer 20 (a light-emitting layer region forming step). In the first semiconductor layer forming step, another semiconductor layer such as a buffer layer may be formed on the substrate 10 before forming the first semiconductor layer 20.

Specifically, in the light-emitting layer region forming step, the quantum well layer 32 including a predetermined number of pairs each having a barrier layer including AlₓGa₁₋ₓN doped with an n-type dopant and a well layer including undoped AlₓGa₁₋ₓN is formed on the first semiconductor layer 20, and then the spacer layer 306 including undoped AlₓGa₁₋ₓN is formed on the quantum well layer 32.

Next, the carrier blocking layer 40 including AlₓGa₁₋ₓN doped with a p-type dopant is formed on the light-emitting layer region 30 (a carrier blocking layer forming step). Here, the carrier blocking layer forming step in the present embodiment includes an impurity introducing step. The impurity introducing step is a step of making the maximum value of the concentration of the impurity of the second conductivity type in the predetermined region from the interface between the light-emitting layer region 30 and the carrier blocking layer 40 in the carrier blocking layer 40 higher than 5 × 10¹⁹ cm⁻³. The timing to start the introduction of the dopant is preferably set to a time when the light-emitting layer region forming step is ended and the carrier blocking layer forming step is started.

Subsequently, the second semiconductor layer 50 including AlₓGa₁₋ₓN doped with a p-type dopant is formed on the carrier blocking layer 40 (a second semiconductor layer forming step). Thereafter, the third semiconductor layer 52 including AlₓGa₁₋ₓN doped with a p-type dopant is further formed on the second semiconductor layer 50 (a third semiconductor layer forming step). In this manner, an epitaxial wafer in which the semiconductor layered structure is formed on the substrate 10 is formed.

Examples of a raw material used in the MOCVD method include organometallic compounds such as trimethylgallium (TMGa), triethylgallium (TEGa), trimethylaluminum (TMAl), and triethylaluminum (TEAl), and ammonia (NH₃). Furthermore, triethylsilane (TESi), for example, may be used as a raw material for the n-type dopant. Biscyclopentadienyl magnesium (Cp₂Mg), for example, may be used as a raw material for the p-type dopant.

Alternatively, hydrogen selenide (H₂Se), disilane (Si₂H₆), monosilane (SiH₄), diethyltellurium (DETe), or dimethyltellurium (DMTe) may be used as a raw material for the n-type dopant. When Zn is used as the p-type dopant, dimethylzinc (DMZn) or diethylzinc (DEZn) may be used as a raw material for such a p-type dopant. Hydrogen or nitrogen, for example, may be used as a carrier gas.

Alternatively, the semiconductor layered structure on the substrate 10 may be formed by other methods for forming a semiconductor layer such as a molecular beam epitaxy (MBE) method.

Next, the epitaxial wafer is taken out from an MOCVD apparatus, and then the semiconductor layered structure formed on the substrate 10 is subjected to a thermal treatment under a predetermined atmosphere at a predetermined temperature for a predetermined amount of time. Subsequently, a photoresist pattern having an opening to expose part of the surface of the third semiconductor layer 52 in the semiconductor layered structure is formed by a photolithography method. Thereafter, the opening is subjected to etching. The etching can be carried out via wet etching and/or dry etching (for example, reactive ion etching). An etched semiconductor layered structure is formed by performing the etching on the surface of the third semiconductor layer 52 corresponding to the opening until the surface of the first semiconductor layer 20 is exposed.

Subsequently, a photoresist pattern having an opening with a predetermined shape in a predetermined region on the externally-exposed surface of the first semiconductor layer 20 is formed by a photolithography method. Thereafter, the first electrode 60 is formed in this opening by a vacuum evaporation method (for example, a resistance heating method, an electron beam evaporation method, a sputtering method, or the like). After the removal of the photoresist pattern used for the formation of the first electrode 60 and washing, the etched semiconductor layered structure with the first electrode 60 is subjected to annealing under an inert atmosphere or under an active atmosphere at a predetermined temperature for a predetermined amount of time to form a semiconductor layered structure with the first electrode 60.

Next, a photoresist pattern having an opening with a predetermined shape in a predetermined region on the surface of the third semiconductor layer 52 in the semiconductor layered structure with the first electrode 60 is formed by a photolithography method. Thereafter, the second electrode 65 is formed by the vacuum evaporation method as with the formation of the first electrode 60. After the removal of the photoresist pattern used for the formation of the second electrode 65 and washing, the semiconductor layered structure with the second electrode 65 is subjected to annealing under an active atmosphere or under an inert atmosphere at a predetermined temperature for a predetermined amount of time to form a wafer having the light-emitting element structure.

The obtained wafer is then cut in a rectangular shape with predetermined dimensions with a device for cutting the wafer such as a dicing device. In this manner, the light-emitting element 1 according to the present embodiment is produced.

In each of the semiconductor layers included in the light-emitting element 1, the conductivity type of the compound semiconductor layer constituting that semiconductor layer may be opposite to that in the present embodiment. For example, the first conductivity type may be p-type, and the second conductivity type may be n-type.

While the light-emitting element 1 that emits light of a wavelength corresponding to the deep ultraviolet light has been described in the present embodiment, a light-emitting element that emits light of a wavelength corresponding to light different from the deep ultraviolet light such as ultraviolet light, blue light, or green light can be formed by controlling the composition of the compound semiconductors that constitute the light-emitting layer region 30 and/or the quantum well structure, for example. The light-emitting layer region 30 may be formed by an active layer undoped or doped with a predetermined dopant, a single quantum well structure, or a multiple quantum well structure.

The planar shape of the light-emitting element 1 is not limited to the above-described embodiment. For example, if the planar dimensions of the light-emitting element 1 are designed so that the longitudinal dimension is shorter than the horizontal dimension, the shape of the light-emitting element 1 in a planar view becomes generally rectangular.

While the present embodiment has described the light-emitting diode structure as an example, a semiconductor laser having the semiconductor layered structure according to the present embodiment can be formed.

### (Effects of embodiment)

The light-emitting element 1 according to the present embodiment can improve the external quantum efficiency of the light-emitting element 1 by setting the maximum value of the concentration of the impurity of the second conductivity type especially in the predetermined region from the interface between the light-emitting layer region 30 and the carrier blocking layer 40 in the carrier blocking layer 40 to be higher than 5 × 10¹⁹ cm⁻³.

### Examples

In Example 1, a light-emitting element having the structure shown in FIG. 1, as with the light-emitting element 1 produced by the production steps according to the embodiment of the present invention, and having the following structure was produced.

First, a 7-mm-square C-plane AlN substrate having a thickness of 500 µm was prepared as a substrate 10. Thereafter, the AlN substrate was set in an MOCVD apparatus. Next, an Al_{0.75}Ga_{0.25}N layer having a thickness of 1.0 µm and doped with Si (wherein the Si concentration is 1 × 10¹⁹ cm⁻³) was formed on the AlN substrate as a first semiconductor layer 20 by the MOCVD method. Thereafter, a quantum well layer including barrier layers and well layers and a spacer layer 306 were formed on the first semiconductor layer 20 as a light-emitting layer region 30.

Al_{0.65}Ga_{0.35}N layer having a thickness of 7 nm and doped with Si was formed as the barrier layer, and an undoped Al_{0.5}Ga_{0.5}N layer having a thickness of 2 nm was formed as the well layer (wherein the Si concentration of the barrier layer is 1 × 10¹⁸ cm⁻³). The quantum well layer was configured to include three well layers and three barrier layers. In other words, three pairs of the barrier layer and the well layer were formed from the first semiconductor layer 20 side. Note that the barrier layers were identical with one another in their composition and thicknesses. Similarly, the well layers were identical with one another in their composition and thicknesses. The spacer layer 306 was further formed on the quantum well layer 32. An undoped Al_{0.65}Ga_{0.35}N layer having a thickness of 20 nm was formed as the spacer layer 306.

Next, an A1N layer having a thickness of 15 nm and doped with Mg was formed on the spacer layer 306 as a carrier blocking layer 40 (wherein the Mg concentration is 5.5 × 10¹⁹ cm⁻³ and the bandgap of AlN is 6.00 eV). The doping with Mg was started from the start of the growth of the carrier blocking layer 40. Thereafter, an Al_{0.80}Ga_{0.20}N layer having a thickness of 35 nm and doped with Mg was formed on the carrier blocking layer 40 as a second semiconductor layer 50 (wherein the Mg concentration is 5.5 × 10¹⁹ cm⁻³). The second semiconductor layer 50 is a semiconductor layer to function as a p-type cladding layer. A GaN layer having a thickness of 30 nm and doped with Mg was further formed on the second semiconductor layer 50 as a third semiconductor layer 52 (wherein the Mg concentration is 2 × 10¹⁹ cm⁻³ and the bandgap of GaN is 3.40 eV). The third semiconductor layer 52 is a semiconductor layer to function as a p-type contact layer. In this manner, the light-emitting element structure was formed on the AlN substrate (hereinafter, referred to simply as a "light-emitting element structure").

Subsequently, the light-emitting element structure was subjected to a thermal treatment in a nitrogen atmosphere under the conditions of 20 minutes and 900°C. Thereafter, a photoresist pattern having an opening with a predetermined shape was formed on a surface of the third semiconductor layer 52 (i.e., the p-type contact layer) by a photolithography method. Next, the opening was subjected to reactive ion etching until a surface of the first semiconductor layer 20 was exposed. Thereafter, a first electrode 60 was formed on the surface of the first semiconductor layer 20 by a vacuum evaporation method. Specifically, the first electrode 60 was formed by forming a Ti layer (wherein the thickness thereof is 20 nm), an Al layer (wherein the thickness thereof is 200 nm), and an Au layer (wherein the thickness thereof is 5 nm) in this order from the first semiconductor layer 20 side. Thereafter, the light-emitting element structure with the first electrode 60 formed was subjected to a thermal treatment in a nitrogen atmosphere under the conditions of one minute and 810°C.

Next, a second electrode 65 was formed on the surface of the third semiconductor layer 52 by a vacuum evaporation method. Specifically, the second electrode 65 was formed by forming an Ni layer (wherein the thickness thereof is 20 nm) and an Au layer (wherein the thickness thereof is 50 nm) in this order from the third semiconductor layer 52 side. Thereafter, the light-emitting element structure with the second electrode 65 formed was subjected to a thermal treatment in an oxygen atmosphere under the conditions of three minutes and 550°C. In this manner, a wafer having the light-emitting structure was produced.

Thereafter, a 700-µm-square chip was cut out from the wafer with a dicing device. In this manner, the nitride semiconductor light-emitting element according to Example 1 was produced.

Thereafter, the characteristics of the produced nitride semiconductor light-emitting element according to Example 1 were evaluated.

Here, X-ray diffractometry (XRD), transmission electron microscope-energy dispersive X-ray spectrometry (TEM-EDX), and a 3-dimensional atom probe (3DAP) were used to evaluate the composition of each of the semiconductor layers. Moreover, a secondary ion-microprobe mass spectrometer (SIMS) was used to evaluate the dopant concentration of each of the semiconductor layers. Furthermore, a photoluminescence method (PL method) was used to evaluate the emission wavelength of the light-emitting layer region 30. These analytical methods were used to confirm that the composition and dopant concentration of each of the semiconductor layers were as described above.

Here, the external quantum efficiency of the light-emitting element 1 is determined in proportion to both of the internal quantum efficiency and the injection efficiency. The internal quantum efficiency is dependent on the crystal quality of the light-emitting layer (for example, the well layer that constitutes the quantum well). When the crystal quality of the light-emitting layer is high, the internal quantum efficiency is improved as compared to a case where the crystal quality is low. When the injection efficiency is low, however, improved internal quantum efficiency has a limitation in improving the external quantum efficiency. Thus, it is effective for the improvement of the external quantum efficiency to improve a function to reduce the flow of carriers in the carrier blocking layer 40 into the second semiconductor layer 50 side and improve the injection efficiency of carriers into the light-emitting layer region 30.

In view of this, light-emitting elements according to Examples 1 and 2 and Comparative Examples 1 to 3 were produced. The light-emitting elements according to Examples 1 and 2 and Comparative Examples 1 to 3 each have a structure generally similar to that of the light-emitting element 1 according to Example 1 except that an Mg concentration in a predetermined region in the carrier blocking layer 40 and the spacer layer 306 is varied on purpose. In other words, regarding Examples 1 and 2 and Comparative Examples 1 to 3, Mg flow rates are varied from Example 1.

Table 1 shows an Mg concentration at the interface and a value of external quantum efficiency in each of these examples and comparative examples.

**[Table 1]**

| | Mg FLOW RATIO RELATIVE TO COMPARATIVE EXAMPLE 3 IN PREDETERMINED REGION | Mg CONCENTRATION (cm⁻³) IN PREDETERMINED REGION | EXTERNAL QUANTUM EFFICIENCY(%) |
|---|---|---|---|
| COMPARATIVE EXAMPLE 1 | 0.15 | 7.4E+18 | 0.10 |
| COMPARATIVE EXAMPLE 2 | 0.76 | 3.8E+19 | 1.37 |
| COMPARATIVE EXAMPLE 3 | 1 | 5.0E+19 | 2.14 |
| EXAMPLE 1 | 1.1 | 5.5E+19 | 2.97 |
| EXAMPLE 2 | 1.2 | 6.1 E+19 | 3.12 |

A tendency that an increased Mg concentration in the predetermined region in the carrier blocking layer 40 leads to improved external quantum efficiency was demonstrated. In other words, it was demonstrated that the external quantum efficiency was improved by introducing the dopant from the start of the growth of the carrier blocking layer 40 and setting the Mg concentration in the predetermined region to be higher than the predetermined concentration. This implies that the function of the carrier blocking layer 40 for the improvement of the injection efficiency has been improved.

Here, in order to enhance the external quantum efficiency, the Mg concentration in the predetermined region is set higher than 5.0 × 10¹⁹ (cm⁻³). According to the light-emitting elements of Examples 1 and 2, setting the Mg concentration in the predetermined region higher than 5 × 10¹⁹ cm⁻³ yields the enhanced effect of the carrier blocking layer and the increased injection efficiency, thus achieving high light-emitting efficiency also in a high injection current region.

While the embodiment and the examples of the present invention have been described above, the above-described embodiment and examples are not intended to limit the invention according to the scope of claims. Moreover, it is to be noted that all combinations of the features described in the embodiment and the examples are not necessarily essential for means for solving the problems of the present invention. Furthermore, a technical element in the above-described embodiment and examples may be applied independently or may be applied in a manner divided into a plurality of parts.

### REFERENCE SIGNS LIST

- 1: light-emitting element
- 10: substrate
- 20: first semiconductor layer
- 30: light-emitting layer region
- 32: quantum well layer
- 40: carrier blocking layer
- 50: second semiconductor layer
- 52: third semiconductor layer
- 60: first electrode
- 65: second electrode
- 100: band diagram
- 200: interface
- 300: barrier layer
- 302: well layer
- 304: well layer
- 306: spacer layer

## Claims

1. A nitride-based semiconductor light-emitting element comprising:
a first semiconductor layer of a first conductivity type;
a second semiconductor layer of a second conductivity type different from said first conductivity type;
a carrier blocking layer of said second conductivity type, provided on a surface of said second semiconductor layer closer to said first semiconductor layer; and
a light-emitting layer region having a light-emitting layer, provided between said first semiconductor layer and said carrier blocking layer, wherein
a predetermined specific region is provided in said carrier blocking layer and extending from an interface between said carrier blocking layer and said light-emitting layer region and wherein a maximum value of a concentration of an impurity of said second conductivity type in said predetermined specific region is higher than 5 × 10¹⁹ cm⁻³.

2. The nitride-based semiconductor light-emitting element according to claim 1, wherein said predetermined specific region is a region of 10 nm from said interface toward said second semiconductor layer.

3. The nitride-based semiconductor light-emitting element according to claim 1 or 2, wherein
said first semiconductor layer is provided on a semiconductor substrate, and
said first semiconductor layer, said second semiconductor layer, said light-emitting layer region, and said carrier blocking layer are configured to include an AlGaN-based semiconductor.

4. The nitride-based semiconductor light-emitting element according to claim 3, wherein
said semiconductor substrate is an AlN substrate, and said first semiconductor layer is provided on a C-plane of said AlN substrate.

5. The nitride-based semiconductor light-emitting element according to any one of claims 1 to 4, wherein the impurity of said second conductivity type is Mg, Zn, Ca, C, or Be.

6. A method for producing a nitride-based semiconductor light-emitting element, comprising:
a first semiconductor layer forming step of forming a first semiconductor layer of a first conductivity type on a semiconductor substrate;
a light-emitting layer region forming step of forming a light-emitting layer region including a light-emitting layer on said first semiconductor layer;
a carrier blocking layer forming step of forming a carrier blocking layer on said light-emitting layer region; and
a second semiconductor layer forming step of forming a second semiconductor layer of a second conductivity type different from said first conductivity type on said carrier blocking layer,
wherein said carrier blocking layer forming step includes an impurity introducing step of forming a predetermined specific region in said carrier blocking layer, said predetermined specific region extending from an interface between said carrier blocking layer and said light-emitting layer region
and wherein a maximum value of a concentration of an impurity of said second conductivity type in said predetermined specific region is higher than 5 × 10¹⁹ cm⁻³.
